Europäisches Patentamt

European Patent Office

Office européen des brevets

(11) Veröffentlichungsnummer: **0 246 478**

**A1**

(12) **EUROPÄISCHE PATENTANMELDUNG**

(21) Anmeldenummer: **87106366.5**

(22) Anmeldetag: **30.04.87**

(51) Int. Cl.⁴: **H03K 17/73 , H03K 17/78**

(30) Priorität: **22.05.86 CH 2079/86**

(43) Veröffentlichungstag der Anmeldung:
**25.11.87 Patentblatt 87/48**

(84) Benannte Vertragsstaaten:
**CH DE FR GB IT LI NL SE**

(71) Anmelder: **BBC Brown Boveri AG**

**CH-5401 Baden(CH)**

(72) Erfinder: **Grüning, Horst Dr.**
**Im Ergel 10**
**CH-5400 Baden(CH)**

(54) **Halbleiter-Leistungsschalter.**

(57) Bei einem Halbleiter-Leistungsschalter mit einem über eine Gateelektrode abschaltbaren Leistungsthyristor (Th1) und einem für die Steuerung des Leistungsthyristors (Th1) vorgesehenen Steuerthyristor (Th2) wird eine Vereinfachung der Ansteuerschaltung dadurch erreicht, dass als Steuerthyristor (Th2) ein feldgesteuerter Thyristor (FCTh) oder ein Thyristor der statischen Induktionsbauart (SITh) verwendet wird.

FIG.1

EP 0 246 478 A1

# HALBLEITER-LEISTUNGSSCHALTER

Die vorliegende Erfindung betrifft einen Halbleiter-Leistungsschalter gemäss dem Oberbegriff des Anspruchs 1. Ein solcher Leistungsschalter ist z.B. aus dem Engineering Sheet Nr. UCZ-82-0002 über den GTO Gate Circuit UCZ 90C12 der Firma Hitachi Ltd., Japan, bekannt.

Ueber eine Gateelektrode abschaltbare Leistungshalbleiter in Form von GTO (Gate Turn Off)-Thyristoren, feldgesteuerten Thyristoren (Field Controlled Thyristor: FCTh) oder Thyristoren der statischen Induktionsbauart (Static Induction Thyristors: SITh) gewinnen in der Leistungselektronik zunehmend an Bedeutung, da bei ihnen Massnahmen zur Kommutierung des Stromes nicht notwendig sind und so eine Vereinfachung der Schaltungen erreicht werden kann.

Andererseits müssen für die abschaltbaren Leistungshalbleiter spezielle Ansteuerungsschaltungen vorgesehen werden. So sollte bei einem GTO im ausgeschalteten Zustand die Gate-Kathoden-Strecke stets mit einer negativen Spannung beaufschlagt werden, um die Sperrfähigkeit und Störsicherheit des GTO zu erhöhen. Desgleichen sollte der GTO im eingeschalteten Zustand stets auch mit einem Steuerstrom versorgt werden, der gleich oder grösser ist als der minimale Zündstrom (siehe dazu z.B. den Artikel von W.Zimmermann in etz-Archiv Bd. 6 (1984), S. 189 ff.).

Aus dem eingangs erwähnten Engineering Sheet ist nun ein Halbleiter-Leistungsschalter bekannt, der im wesentlichen einen abschaltbaren Leistungsthyristor und die dazugehörige Ansteuerschaltung umfasst.

Die bekannte Ansteuerschaltung enthält neben mehreren Stufen zur Steuersignalverstärkung und -formung im Ausgang einen Leistungs-Darlington-Transistor und als Steuerthyristor einen GTO-Thyristor, welche die erforderlichen Steuerströme für das An-und Abschalten des Leistungs-GTO zur Verfügung stellen.

Wird durch die vorangehenden Signalstufen der Darlington-Transistor durchgeschaltet, erhält der Leistungs-GTO aus einer entsprechenden Spannungsquelle einen positiven Gatestrom und -schaltet ein. Wird dagegen der GTO-Thyristor in der Ansteuerung von den Signalstufen durchgeschaltet, erhält der Leistungs-GTO aus einer anderen Spannungsquelle einen negativen Gatestrom und schaltet ab.

Da in der bekannten Ansteuerschaltung zur Steuerung ein GTO-Thyristor eingesetzt ist, gelten für diesen Thyristor dieselben einschränkenden Ueberlegungen, wie sie oben für einen GTO allgemein dargestellt worden sind. Auch hier muss Vorsorge getroffen werden, dass der GTO-Thyristor in seinen Schaltzuständen stabil bleibt. Dies führt jedoch zu einer deutlichen Verkomplizierung der Ansteuerschaltung.

Aufgabe der vorliegenden Erfindung ist es nun, einen Halbleiter-Leistungsschalter zu schaffen, der hinsichtlich seiner Ansteuerung vereinfacht aufgebaut und betrieben werden kann.

Die Aufgabe wird bei einem Halbleiter-Leistungsschalter der eingangs genannten Art durch die Merkmale aus dem Kennzeichen des Anspruchs 1 gelöst.

Der Kern der Erfindung besteht darin, als Steuerthyristor für einen abschaltbaren Leistungsthyristor einen feldgesteuerten Thyristor (FCTh) oder einen Thyristor der statischen Induktionsbauart (SITh) einzusetzen. Diese Thyristoren haben, im Unterschied zum GTO-Thyristor, die Eigenschaft, ohne Ansteuerung im Durchlasszustand zu sein. Hierdurch kann die Ansteuerung des abschaltbaren Leistungsthyristors wesentlich vereinfacht werden.

Besonders einfach lässt sich der Halbleiter-Leistungsschalter aufbauen, wenn gemäss einem bevorzugten Ausführungsbeispiel der Erfindung als Leistungsthyristor ebenfalls ein FCTh oder SITh verwendet wird. In diesem Falle reduziert sich die Ansteuerschaltung auf nur einige wenige Bauelemente.

Nachfolgend soll die Erfindung im Zusammenhang mit der Zeichnung anhand von Ausführungsbeispielen näher erläutert werden. Es zeigen:

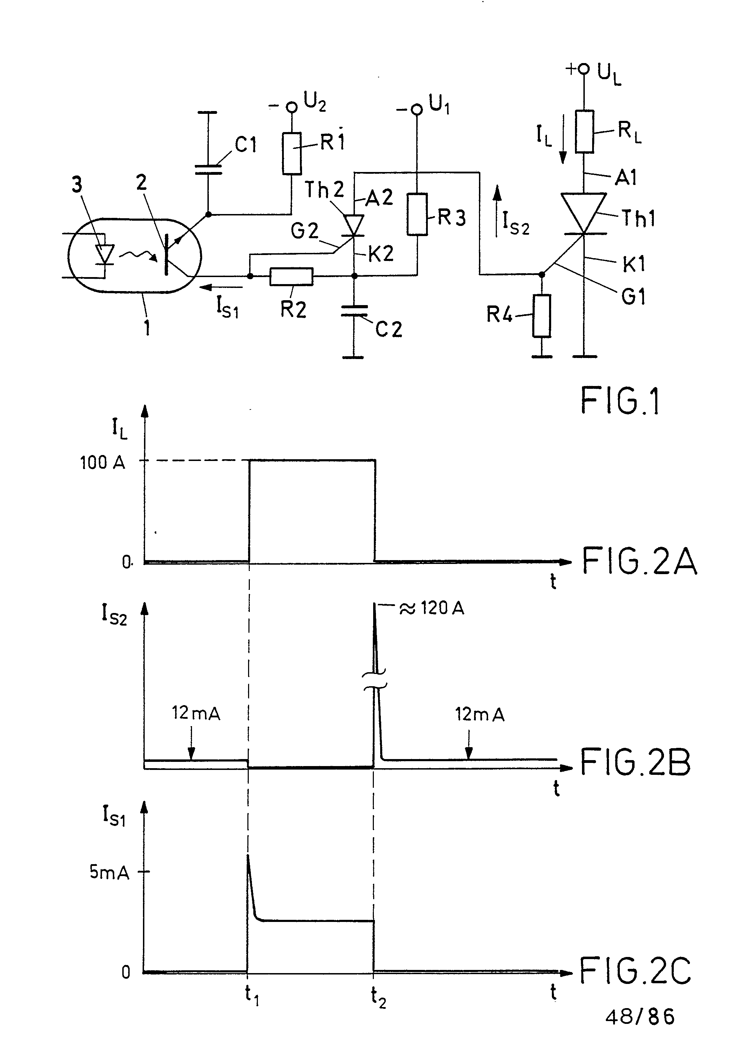

Fig. 1 ein bevorzugtes Ausführungsbeispiel des erfindungsgemässen Halbleiter-Leistungsschalters mit zwei feldgesteuerten Thyristoren,

Fig. 2 A-C
die zeitlichen Verläufe verschiedener Ströme beim Ein-und Ausschalten in einer Schaltung nach Fig. 1, und

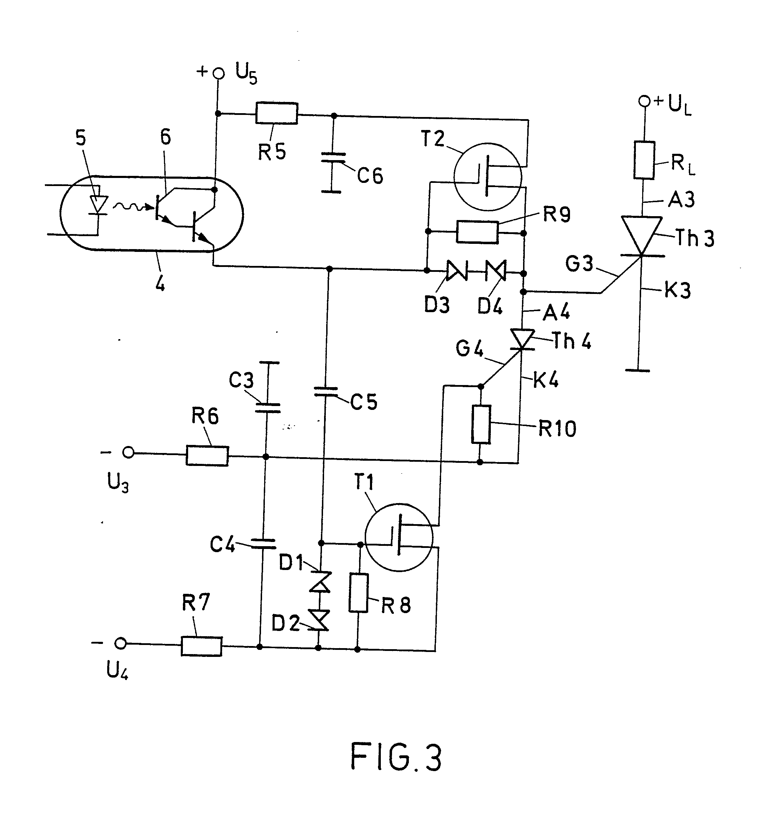

Fig. 3 ein weiteres Ausführungsbeispiel der Erfindung mit einem GTO als Leistungsthyristor.

Im Ausführungsbeispiel der Fig. 1 ist ein abschaltbarer Leistungsthyristor Th1 in Form eines feldgesteuerten Thyristors FCTh in Reihe mit einem Lastwiderstand $R_L$ zwischen den positiven Pol einer Lastspannung $U_L$ und der Schaltungsmasse geschaltet, wobei die Kathode K1 an Schaltungsmasse liegt und die Anode A1 entsprechend mit der positiven Spannung beaufschlagt ist.

Das Gate G1 des Leistungsthyristors Th1 ist einerseits über einen Widerstand R4 mit der Schaltungsmasse verbunden, andererseits direkt an die Anode A2 eines gleichfalls als FCTh ausgebildeten Steuerthyristors Th2 angeschlossen.

Die Kathode K2 des Steuerthyristors Th2 liegt über einen Vorwiderstand R3 an einer ersten negativen Versorgungsspannung $U_1$. Die Kathode K2 ist weiterhin durch einen Kondensator C2 wechselspannungsmässig mit der Schaltungsmasse verbunden und über einen Widerstand R2 an das Gate G2 des Steuerthyristors Th2 angeschlossen.

Eingangsseitig ist als Ansteuereinrichtung ein Optokoppler 1 vorgesehen, der im Eingang eine Leuchtdiode 3 und im Ausgang einen Phototransistor 2 aufweist.

Das Gate G2 des Steuerthyristors Th2 führt auf den Kollektor des Phototransistors 2, während dessen Emitter über einen weiteren Vorwiderstand R1 mit einer zweiten negativen Versorgungsspannung $U_2$ beaufschlagt wird und zugleich über einen Kondensator C1 an Schaltungsmasse liegt.

Im Ausführungsbeispiel der Fig. 1 können die Werte der aufgeführten Bauelemente wie folgt gewählt werden:

$\quad$ Th1: Laststrom $I_L = 100$ A
Schaltfrequenz f = 10 kHz
$\quad$ R1: 1 k$\Omega$
$\quad$ C1: 10 $\mu$F
$\quad$ R2: 10 k$\Omega$
$\quad$ C2: 100 $\mu$F
$\quad$ R3: 100 $\Omega$
$\quad$ R4: 4,7 k$\Omega$

$\quad$ $U_1$ 60 V bei 30 mA
$\quad$ $U_2$ 80 V bei 2 mA

Der Steuerthyristor Th2 kann dabei hinsichtlich seiner Leistungsdaten wesentlich kleiner dimensioniert werden als der Leistungsthyristor Th1.

Die FCTh-Thyristoren Th1 und Th2 aus der Schaltung der Fig. 1 können z.B. eine Struktur aufweisen, wie sie in der EP-A1 0 121 068 beschrieben ist. Gleiches gilt auch für den Steuerthyristor Th4 in der später erläuterten Schaltung aus Fig. 3.

Die Funktion der Schaltung nach Fig. 1 kann nun in Verbindung mit den zeitlichen Verläufen verschiedener Ströme aus den Fig. 2A-C verdeutlicht werden. Gezeigt werden in diesen Figuren die Verläufe des bereits erwähnten Laststromes $I_L$ (Fig. 2A) durch den Lastwiderstand $R_L$, eines ersten Steuerstroms $I_{S1}$ durch den Kollektor des Phototransistors 2 (Fig. 2B) sowie eines zweiten Steuerstroms $I_{S2}$ durch die Anode A2 des Steuerthyristors Th2 (Fig. 2C). Alle Ströme sind in Fig. 1 durch entsprechende Pfeile markiert.

Ausgehend von einem Zustand zur Zeit t = 0, in dem der Leistungsthyristor Th1 gesperrt ist ($I_L = 0$ in Fig. 2A), wird zum Zeitpunkt t = $t_1$ der Laststrom $I_L$ durch den Leistungsthyristor Th1 ein- und zum Zeitpunkt t = $t_2$ wieder abgeschaltet.

Diese Schaltfunktion des Leistungsthyristors Th1 wird durch einen geeignet gewählten zweiten Steuerstrom $I_{S2}$ (Fig. 2B) sichergestellt, der über das Gate G1 des Leistungsthyristors Th1 fliesst. Da der Leistungsthyristor Th1 als FCTh im unangesteuerten Zustand durchgeschaltet ist, wird für den Sperrzustand in den Zeiten t < $t_1$ und t > $t_2$ ein endlicher zweiter Steuerstrom $I_{S2}$ benötigt, der in diesem Fall die Höhe von etwa 12 mA hat. Im Durchlasszustand dagegen ($t_1 < t < t_2$) ist der zweite Steuerstrom $I_{S2}$ gleich Null.

Der zweite Steuerstrom $I_{S2}$ aus Fig. 2B wird von dem Steuerthyristor Th2 bereitgestellt, der seinerseits über sein Gate G2 mit dem ersten Steuerstrom $I_{S1}$ gesteuert wird. Da der Steuerthyristor Th2 immer dann abgeschaltet ist, wenn der Leistungsthyristor Th1 eingeschaltet ist und umgekehrt, ist der erste Steuerstrom $I_{S1}$ zum zweiten Steuerstrom $I_{S2}$ gegenläufig, d.h. $I_{S1}$ verschwindet, wenn $I_{S2}$ seinen Wert von 12 mA annimmt (für t < $t_1$ und $t_2$ < t), und hat einen Wert von etwa 2,5 mA, wenn $I_{S2}$ Null ist (für $t_1$ < t < $t_2$).

Besonderheiten für den ersten Steuerstrom $I_{S1}$ der Fig. 2C und den zweiten Steuerstrom $I_{S2}$ der Fig. 2B ergeben sich für die Zeitpunkte $t_1$ und $t_2$, in denen der Leistungsthyristor Th1 ein-bzw. ausgeschaltet wird. Bei diesen Besonderheiten handelt es sich um peak-förmige Stromimpulse, die in den Figuren 2B und C als Spitzen eingezeichnet sind. Diese Stromimpulse lassen sich durch die nachfolgend beschriebene Arbeitsweise der Schaltung aus Fig. 1 erklären:

In der Zeit 0 < t < $t_1$ ist der Leistungsthyristor Th1 gesperrt, während der Steuerthyristor Th2 leitend ist. Am Gate G1 des Leistungsthyristors Th1 liegt die volle Spannung von -60 V (Versorgungsspannung $U_1$). Der zweite Steuerstrom $I_{S2}$ durch die Anode A2 des Steuerthyristors Th2 setzt sich zusammen aus dem Strom durch den Widerstand R4 und dem Leckstrom über das Gate G1 des Leistungsthyristors Th1. Der Phototransistor 2 wird von der Leuchtdiode 3 wegen des fehlenden Eingangssignals nicht angesteuert und ist daher gesperrt. An Kathode K2 und Gate G2 des Steuerthyristors Th2 liegt etwa dieselbe Spannung.

Zum Zeitpunkt $t_1$ wird nun der Phototransistor 2 durch die Leuchtdiode 3 eingeschaltet. Der erste Steuerstrom $I_{S1}$ räumt dann zunächst mit einem Stromstoss von über 5mA (Stromspitze bei $t_1$ in Fig. 2C) die Sperrschichtladung im Gate-Kathodenbereich des Steuerthyristors Th2 aus. Zwischen dem Gate G2 und der Kathode K2 liegt eine Spannung von -20 V. Der Steuerthyristor Th2 sperrt. Die entsprechende Sperrschichtkapazität in der Gate-Kathodenstrecke des Leistungsthyristors Th1 entlädt sich über den Widerstand $R_4$ und in Form des Gatestroms, der beim Einschalten von Th1 fliesst.

In der Zeit $t_1 < t < t_2$ wird nach dem Schaltvorgang ein stationärer Zustand erreicht, in dem der Leistungsthyristor Th1 einen Laststrom $I_L$ von etwa 100 A führt, der zweite Steuerstrom $I_{S2}$ gleich Null ist, und der erste Steuerstrom etwa 2,5 mA beträgt. Der erste Steuerstrom $I_{S1}$ setzt sich dabei zusammen aus dem Strom durch den Widerstand R2 und den Leckstrom über das Gate G2. Der Steuerthyristor Th2 ist gesperrt. Der Leistungsthyristor Th1 leitet den Laststrom und weist zwischen G1 und K1 eine positive Spannung von etwa 1V auf, die aus dem Strom durch A1 resultiert.

Der stationäre Zustand zwischen $t_1$ und $t_2$ wird durch einen weiteren Schaltvorgang im Zeitpunkt $t_2$ beendet. Wenn in $t_2$ das Eingangssignal an der Leuchtdiode 3 des Optokopplers 1 abfällt, sperrt der Phototransistor 2 und der erste Steuerstrom $I_{S1}$ verschwindet. Die Sperrschichtkapazität zwischen G2 und K2 des Steuerthyristors Th2 entlädt sich über den Widerstand R2 und mit dem Strom aus der Anode A2 beim Einschalten des Steuerthyristors Th2.

Der Steuerthyristor Th2 übernimmt dann den Gatestrom durch G1 und der Leistungsthyristor Th schaltet ab. Hierbei fliesst kurzzeitig (für eine Zeit sehr viel kleiner als 2 μs) ein zweiter Steuerstrom von etwa 120 A Spitzenstärke (siehe Fig. 2B). Nach dem Abklingen dieses Abschaltstromes wird für $t > t_2$ wieder ein stationärer Zustand erreicht, der demjenigen für $t < t_1$ gleicht.

Vergleicht man den Halbleiter-Leistungsschalter aus Fig. 1 mit der bekannten, eingangs erwähnten Anordnung aus dem Engineering Sheet, wird sofort deutlich, wie stark der Schaltungsaufbau durch Verwendung zweier feldgesteuerter Thyristoren als Steuer-und Leistungsthyristor vereinfacht werden kann.

Aber auch, wenn nur der Steuerthyristor als FCTh oder SITh ausgebildet ist, der Leistungsthyristor dagegen in herkömmlicher Weise ein GTO ist, ergeben sich aus den o.g. Gründen Vereinfachungen in Schaltung und Wirkungsweise. Dieser Fall soll anhand des Ausführungsbeispiels aus Fig. 3 näher betrachtet werden.

In der Schaltung nach Fig. 3 ist als Leistungsthyristor Th3 ein GTO-Thyristor, als Steuerthyristor Th4 ein FCTh oder SITh eingesetzt. Der Leistungsthyristor Th3 ist mit seiner Anode A3 und seiner Kathode K3 in gleicher Weise über den Lastwiderstand $R_L$ mit der Lastspannung $U_L$ verbunden wie der Leistungsthyristor Th1 in Fig. 1.

Das Gate G3 des Leistungsthyristors Th3 ist direkt mit der Anode A4 des Steuerthyristors Th4 verbunden. Das Gate G4 des Steuerthyristors Th4 ist über die Drain-Source-Strecke eines ersten, als FET ausgebildeten Transistors T1 und einen Vorwiderstand R5 an eine vierte negative Versorgungsspannung $U_4$ angeschlossen. Zugleich steht das Gate G4 über einen Widerstand R10 mit der entsprechenden Kathode K4 in Verbindung. Die Kathode K4 ihrerseits ist über einen weiteren Vorwiderstand R6 mit einer dritten negativen Versorgungsspannung $U_3$ beaufschlagt.

Die beiden Vorwiderstände R6 und R7 sind auf ihrer der Versorgungsspannung ($U_3$ bzw. $U_4$) abgewandten Seite über einen Kondensator C4 wechselspannungsmässig verbunden, die Kathode K4 mit der Schaltungsmasse über einen weiteren Kondensator C3.

Das Gate G3 des Leistungsthyristors Th3 liegt über die Drain-Source-Strecke eines zweiten, als FET ausgebildeten Transistors T2 und einen Vorwiderstand R5 an einer fünften, positiven Versorgungsspannung $U_5$. Zwischen dem zweiten Transistor T2 und dem Vorwiderstand R5 ist ein weiterer Kondensator C6 angeschlossen, der eine Verbindung zur Schaltungsmasse herstellt.

Beide Transistoren T1 und T2 weisen an ihrem Gate jeweils zur Einstellung und Begrenzung der Gatevorspannung eine Parallelschaltung aus einem Zenerdiodenpaar und einem Widerstand auf (Zenerdioden D1 und D2 und Widerstand R8 bei Transistor T1; Zenerdioden D3 und D4 und Widerstand R9 bei Transistor T2).

Beide Transistoren T1 und T2 werden von einem Optokoppler 4 angesteuert, der eingangsseitig wiederum eine Leuchtdiode 5, ausgangsseitig wegen der notwendigen höheren Stromverstärkung aber einen Photodarlington 6 aufweist. Der Kollektor des Photodarlington 6 liegt an der fünften, positiven Versorgungsspannung $U_5$. Der Emitter des Photodarlington 6 ist einerseits mit dem Gate des zweiten Transistors T2 direkt, mit dem Gate des ersten Transistors T1 dagegen über einen Kondensator C5 verkoppelt.

Für die Schaltung der Fig. 3 haben sich folgende Bauelemente und Werte bewährt:

Th3: Laststrom 100 - 300 A
T1: Typ MFE 990 (Motorola)
T2: Typ MTP 12 N 06 (Motorola)
D1 ... D4: Typ ZPD 15
R5: 2 Ω
R6: 100 Ω
R7: 220 Ω
R8: 100 kΩ
R9: 1 kΩ
R10: 2,2 kΩ
C3: 1 mF
C4: 100 μF

C5: 100 nF
C6: 50 µF

U₃: 12 V bei 50 mA
U₄: 24 V bei 5 mA
U₅: 12 V bei 8 A

Die Funktion der Schaltung nach Fig. 3 ist die folgende: Um den GTO-Leistungsthyristor Th3 einzuschalten, muss zunächst der Optokoppler 4 über die Leuchtdiode 5 angesteuert werden. Der Photodarlington 6 wird dann leitend und schaltet den zweiten Transistor T2 ein. Ist der zweite Transistor T2 eingeschaltet, entlädt sich der aufgeladene Kondensator C6 mit einem peakförmigen Triggerstrom auf das Gate G3 des Leistungsthyristors Th3 und schaltet diesen ein.

Zu gleicher Zeit wird auch der erste Transistor T1 über den Kondensator C5 eingeschaltet. Damit wird das Gate G4 des Steuerthyristors Th4 auf die gegenüber der Kathode K4 negtive vierte Versorgungsspannung U₄ gelegt und Th4 sperrt.

Schliesslich fliesst über den Vorwiderstand R5 und die Source-Drain-Strecke des zweiten Transistors T2 ein Dauerhaltestrom, der ein sicheres Verbleiben des Leistungsthyristors Th3 im eingeschalteten Zustand gewährleistet.

Um den Leistungsthyristor Th3 wieder auszuschalten, wird zunächst der Optokoppler 4 abgeschaltet. Der Photodarlington 6 sperrt. Dies hat zur Folge, dass beide Transistoren T1 und T2 abschalten. Mit dem Abschalten des ersten Transistors T1 geht das Einschalten des Steuerthyristors Th4 einher. Ist Th4 durchgeschaltet, fliesst über den Kondensator C3 ein hoher peakförmiger Abschaltstrom aus dem Gate G3, der den Leistungsthyristor Th3 abschaltet. Durch die dritte negative Versorgungsspannung U₃ und den eingeschalteten Steuerthyristor Th4 bleibt G3 weiterhin auf negativem Potential, so dass ein sicheres Abschalten gewährleistet ist.

Insgesamt wird mit der Erfindung ein Halbleiterleistungsschalter zur Verfügung gestellt, der sich bei vereinfachtem Aufbau durch einen sicheren Betrieb auszeichnet.

Besonders vorteilhaft ist es weiterhin, die beiden im Leistungsschalter verwendeten Thyristoren (Th1, Th2 in Fig. 1 bzw. Th3, Th4 in Fig. 3) zu einer Einheit zusammenzufassen, weil hierdurch der schaltungstechnische Aufbau weiter vereinfacht und der damit verbundene Aufwand weiter verringert werden kann.

Die Zusammenfassung kann nach Art eines Moduls dadurch erfolgen, dass die an sich getrennten Thyristortabletten auf einem gemeinsamen Keramiksubstrat in einem gemeinsamen Gehäuse untergebracht werden.

Sind beide Thyristoren in der gleichen Technologie herstellbar (wenn z.B. beide Thyristoren vom FCTh-Typ sind), ist es besonders günstig, die Thyristoren auf einem gemeinsamen Halbleitersubstrat monolithisch zu integrieren und so die Herstellung zu vereinfachen und die Abstimmung der Bauelemente aufeinander zu optimieren.

**Ansprüche**

1. Halbleiter-Leistungsschalter mit einem über eine Gateelektrode abschaltbaren Leistungsthyristor und einer mit dem Gate des Leistungsthyristors verbundenen Ansteuerschaltung zum Ein-und Ausschalten des Leistungsthyristors, welche Ansteuerschaltung einen Steuerthyristor in einer Anordnung aufweist, derart, dass der Steuerthyristor gesperrt ist, wenn sich der Leistungsthyristor im Durchlasszustand befindet und umgekehrt, dadurch gekennzeichnet, dass der Steuerthyristor (Th2, Th4) ein feldgesteuerter Thyristor (Field Controlled Thyristor: FCTh) oder ein Thyristor der statischen Induktionsbauart (Static Induction Thyristor: SITh) ist.

2. Halbleiter-Leistungsschalter nach Anspruch 1, dadurch gekennzeichnet, dass auch der abschaltbare Leistungsthyristor (Th1, Th3) ein feldgesteuerter Thyristor oder ein Thyristor der statischen Induktionsbauart ist.

3. Halbleiter-Leistungsschalter nach Anspruch 2, dadurch gkennzeichnet, dass

(a) der Steuerthyristor (Th2) mit seiner Anode (A2) am Gate (G1) des Leistungsthyristors (Th1) angeschlossen ist;

(b) die Kathode (K2) des Steuerthyristors (Th2) über einen Kondensator (C2) mit der Schaltungsmasse verbunden und mit einer ersten negativen Versorgungsspannung (U₁) beaufschlagt ist;

(c) das Gate (G2) des Steuerthyristors (Th2) mit einer Ansteuereinrichtung und über einen Widerstand (R2) mit der Kathode (K2) verbunden ist; und

(d) das Gate (G1) des Leistungsthyristors (Th1) über einen Widerstand (R4) mit der Kathode (K1) verbunden ist.

4. Halbleiter-Leistungsschalter nach Anspruch 3, dadurch gekennzeichnet, dass

(a) die Ansteuereinrichtung einen Optokoppler (1) mit einer eingangsseitigen Leuchtdiode (3) und einem ausgangsseitigen Phototransistor (2) aufweist,

(b) der Kollektor des Phototransistors (2) mit dem Gate (G2) des Steuerthyristors (Th2) verbunden ist;

(c) der Emitter des Phototransistors (2) über einen Vorwiderstand (R1) mit einer zweiten negativen Versorgungsspannung ($U_2$), welche grösser ist als die erste negative Versorgungsspannung ($U_1$), beaufschlagt ist; und

(d) der Emitter des Phototransistors (2) weiterhin über einen Kondensator (C1) mit der Schaltungsmasse verbunden ist.

5. Halbleiter-Leistungsschalter nach Anspruch 1, dadurch gekennzeichnet, dass der abschaltbare Leistungsthyristor (Th1, Th3) ein über das Gate abschaltbarer Thyristor vom GTO (Gate Turn Off)-Typ ist.

6. Halbleiter-Leistungsschalter nach Anspruch 5, dadurch gekennzeichnet, dass

(a) der Steuerthyristor (Th4) mit seiner Anode (A4) an das Gate (G3) des Leistungsthyristors (Th3) angeschlossen ist;

(b) die Kathode (K4) des Steuerthyristors (Th4) über einen Kondensator (C3) mit der Schaltungsmasse verbunden und mit einer dritten negativen Versorgungsspannung ($U_3$) beaufschlagt ist;

(c) das Gate (G4) des Steuerthyristors (Th4) über einen ersten Transistor (T1) mit einer Ansteuereinrichtung verbunden ist; und

(d) das Gate (G3) des Leistungsthyristors (Th3) über einen zweiten Transistor (T2) mit der Ansteuereinrichtung verbunden ist.

7. Halbleiter-Leistungsschalter nach Anspruch 6, dadurch gekennzeichnet, dass

(a) der erste und zweite Transistor (T1, T2) Feldeffekttransistoren sind;

(b) die Ansteuereinrichtung einen Optokoppler (4) mit einer eingangsseitigen Leuchtdiode (5) und einem ausgangsseitigen Photodarlington (6) umfasst;

(c) das Gate des ersten Transistors (T1) über einen Kondensator (C5) und das Gate des zweiten Transistors (T2) direkt mit dem Emitter des Photodarlington (6) verbunden sind;

(d) die Drain-Source-Strecke des ersten Transistors (T1) zwischen dem Gate (G4) des Steuerthyristors (Th4) und einer vierten negativen Versorgungsspannung ($U_4$) liegt;

(e) die Drain-Source-Strecke des zweiten Transistors (T2) zwischen dem Gate (G4) des Steuerthyristors (Th4) und einer positiven Versorgungsspannung ($U_5$) liegt, mit welcher zugleich der Kollektor des Photodarlingtons (6) beaufschlagt ist; und

(f) ein Kondensator (C6) von der Drainelektrode des zweiten Transistors (T2) zur Schaltungsmasse führt.

8. Halbleiter-Leistungsschalter nach Anspruch 1, dadurch gekennzeichnet, dass der Leistungsthyristor (Th1, Th3) und der Steuerthyristor (Th2, Th4) nach Art eines Moduls in einem gemeinsamen Gehäuse untergebracht sind.

9. Halbleiter-Leistungsschalter nach Anspruch 1, dadurch gekennzeichnet, dass der Leistungsthyristor (Th1, Th3) und der Steuerthyristor (Th2, Th4) auf einem gemeinsamen Halbleitersubstrat monolithisch integriert sind.

FIG.1

FIG.2A

FIG.2B

FIG.2C

FIG.3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-3 821 565  (HORINAGA)<br>* Zusammenfassung;  Figuren  1,4;<br>Spalte  1,  Zeile  60 - Spalte  5,<br>Zeile 2; Anspruch 11 *<br><br>--- | 1 | H 03 K  17/73<br>H 03 K  17/78 |
| A | US-A-4 456 836  (MATSUDA et al.)<br>* Figuren 1a-2b; Zusammenfassung;<br>Spalte 2, Zeile 43  -  Spalte  5,<br>Zeile 43 *<br><br>--- | 1,5-7 | |
| A | DE-A-3 425 414  (SIEMENS)<br>* Figur 1; Zusammenfassung; Seite<br>7, Zeilen 13-21; Anspruch 6 *<br><br>----- | 2,5 | |

|  | RECHERCHIERTE SACHGEBIETE (Int. Cl.4) |
|---|---|
|  | H 03 K<br>H 02 M |

Der vorliegende Recherchenbericht wurde für alle Patentansprüche erstellt.

| Recherchenort | Abschlußdatum der Recherche | Prüfer |
|---|---|---|
| DEN HAAG | 20-08-1997 | HARTBERGER, J. |